# EUROPÄISCHE PATENTANMELDUNG

(11) **EP 3 547 338 A1**
(43) Veröffentlichungstag der Anmeldung: **02.10.2019**
(21) Anmeldenummer: 19168618.7
(22) Anmeldetag: 02.03.2017
(51) Int. Cl.: H01F 27/28, H05K 1/16, H01F 3/14, H01F 27/30

(54) **ELEKTRONISCHES BAUELEMENT UND VERFAHREN ZU DESSEN HERSTELLUNG**

(30) Priorität: 04.03.2016 DE 102016203613
(62) Teilanmeldung aus: 17708487.8
(71) Anmelder: Würth Elektronik GmbH & Co. KG, 74676 Niedernhall (DE)
(72) Erfinder: SCHWERSENZ, Anatol, 74172 Neckarsulm (DE); SCHWIERTZ, Sebastian, 74523 Schwäbisch Hall (DE)
(74) Vertreter: Richardt Patentanwälte PartG mbB

(57) **Zusammenfassung**

Die Erfindung betrifft ein elektronisches Bauelement mit einer Kavität (4), in der ein magnetischer Kreis angeordnet ist, wobei der magnetische Kreis durch erste (5) und zweite (6) magnetische Leitelemente gebildet wird, zwischen denen sich zumindest eine Planarspule (7; 15, 16) befindet, wobei die magnetischen Leiterelemente jeweils zumindest einen brückenförmigen Bereich (12, 13) aufweisen, und die Windungen der Planarspule zwischen den brückenförmigen Bereichen der magnetischen Leitelemente hindurch verlaufen, wobei die brückenförmigen Bereiche jeweils ein erstes Ende (8, 10) aufweisen, wobei durch die aneinander gegenüberliegenden ersten Enden ein Spulenkern für die Planarspule gebildet wird, und die brückenförmigen Bereiche jeweils ein zweites Ende (9', 9"; 11', 11") aufweisen, wobei durch die einander gegenüberliegenden zweiten Enden der magnetische Kreis an der Peripherie der Planarspule geschlossen wird. Die ersten und zweiten magnetischen Leiterelemente sind so ausgebildet, dass sich die jeweils gegenüberliegenden zweiten Enden mit deren Stirnflächen berühren und ein Luftspalt (14) zwischen den ersten Enden der Leiterelemente in einem Zentrum der zumindest einen Planarspule ausgebildet ist

## Beschreibung

Die Erfindung betrifft ein elektronisches Bauelement zur Realisierung einer Induktivität, insbesondere eines Transformators, und ein Verfahren zur Herstellung eines elektronischen Bauelements.

Die vorliegende Patentanmeldung ist eine Teilanmeldung zur Stammanmeldung PCT/EP2017/054872, deren Offenbarungsgehalt vollumfänglich zum Gegenstand der vorliegenden Teilanmeldung gemacht wird.

Aus dem Stand der Technik sind an sich Planarspulen bekannt, bei denen die Spulenwindungen auf die Oberfläche eines Substrats aufgebracht werden. Mit solchen bekannten Planarspulen lässt sich kosteneffizient nur eine relativ geringe Induktivität erreichen, wobei die Planarspulen außerdem relativ viel Platz auf der Substratoberfläche einnehmen.

Aus DE 10 2012 216101 ist ein Verfahren zum Herstellen einer in einem Substrat integrierten oder auf einem Substrat aufgebrachten Spule bekannt, wobei Windungsabschnitte der Spule durch das Kernmaterial der Spule hindurch verlaufen.

Aus US 2012/0011709 A1 ist ein diskretes elektronisches Bauelement mit einer Induktivität bekannt, welches einen zylinderförmigen Spulenkern hat.

Die Druckschrift US 2009/0237899 A1 offenbart eine magnetische Komponente, die in einer Leiterplatte angeordnet ist. Die Leiterplatte weist dazu eine Ausnehmung auf, in der ein E-förmiges Kernelement einbringbar ist. In dieses E-förmige Kernelement kann eine Spule eingebracht und an dem E- förmigen Kernelement kann oberseitig ein stabförmiges Element vorgesehen werden.

Die US 6 996 892 B1 beschreibt eine Leiterplatte mit einer eingebetteten Induktionsspule und ein Verfahren zum Herstellen der Leiterplatte. Der Prozess beginnt mit dem Bereitstellen einer Kernstruktur mit einer dielektrischen Kernschicht und einer ersten Metallschicht auf einer oberen Oberfläche der dielektrischen Kernschicht. Die erste Metallschicht wird geätzt, um erste Induktionsspulenwicklungen zu bilden. Ein Material, wie beispielsweise ein Epoxymaterial, das ein magnetisches Füllmaterial enthält, wird über den ersten Induktionsspulenwicklungen abgeschieden. Danach wird eine Prepreg-Schicht über dem auf den ersten Induktionsspulenwicklungen abgeschiedenen Material aufgebracht und an diesem befestigt, um die Leiterplatte mit der eingebetteten Induktionsspule zu bilden.

Die DE 10 2014 114205 A1 beschreibt eine induktive Vorrichtung, welche ein Paar von halbschalenartigen magnetisch leitenden Gehäusen aufweist, die zusammengefügt sind und eine umschlossene Ausnehmung zwischen diesen bilden. Die induktive Vorrichtung weist ferner eine Primär- und eine Sekundärwicklung auf, die räumlich innerhalb der Ausnehmung vorgesehen sind und eine magnetische Kopplung zwischen diesen schaffen. Die Wicklungen sind elektrisch gegeneinander isoliert, und Anschlüsse der Primär- und der Sekundärwicklung verlaufen zu einer Außenseite der induktiven Vorrichtung.

Die US 5 479 695 A beschreibt magnetische Bauteile, welche als monolithische Strukturen unter Verwendung von mehrschichtig gebrannten keramischen Bandverfahren hergestellt werden. Bei der Herstellung dieser magnetischen Komponenten werden mehrere Schichten aus einem magnetischen Material und einem isolierenden nichtmagnetischen Material erzeugt, um eine monolithische Struktur mit gut definierten magnetischen und isolierenden nichtmagnetischen Bereichen zu bilden. Wicklungen werden unter Verwendung von mittels Siebdruck erzeugten Leitern gebildet, die durch leitende Durchgänge durch die Mehrschichtstruktur verbunden sind.

Die US 2012/161911 A1 beschreibt eine Induktionsvorrichtung, welche ein Gehäuse, einen Spulenhalter, eine Spule, die im Gehäuse angeordnet ist und mit dem Spulenhalter gehalten wird, und einen Kern umfasst, der im Gehäuse angeordnet ist. Die Spule erstreckt sich spiralförmig um den Kern. Der Kern und der Spulenhalter sind separat am Gehäuse befestigt.

Die US 2005/270745 A1 beschreibt einen Leistungswandler, welcher mindestens einen planaren Transformator integriert, der ein Mehrschichttransformatorsubstrat umfasst, und/oder mindestens eine planare Induktivität, die ein Mehrschichtinduktivitätssubstrat umfasst, mit einer Anzahl von Leistungshalbleiterschaltern, die über einen oder mehrere Mehrschicht-Switchsubstrate physikalisch und thermisch mit einer Wärmesenke gekoppelt sind.

Die US 8 427 269 B1 beschreibt eine gekapselte elektronische Vorrichtung, welche eine magnetisch permeable Kernstruktur umfasst, die innerhalb einer ebenen oberen Oberfläche der Vorrichtung liegt und koplanar zu dieser ist. Eine Bodenfläche des Kerns kann innerhalb der Bodenfläche der Vorrichtung freigelegt sein. Die untere Kernfläche kann unterliegend unter, koplanar mit oder hervorstehend von der unteren Fläche der Vorrichtung sein. Alternativ kann die Bodenfläche in der Vorrichtung eingeschlossen sein. Ein Verfahren zum Herstellen des freiliegenden Kernpakets umfasst das Positionieren einer ersten Komponente relativ zu einer zweiten Komponente vor dem Einkapseln der Vorrichtung. Eine verbesserte planare Magnetkernstruktur umfasst innere Fasen mit einem Radius größer oder gleich 15% und vorzugsweise 25%, 35% oder bis zu 50% der Kerndicke, um die Konzentration des Magnetfeldes um die inneren Ecken herum zu reduzieren.

Die DE 10 2008 049756 A1 beschreibt einen Schaltungsträger, der mit mindestens einem Transformator ausgestattet ist, welcher vollständig innerhalb des Schaltungsträgers angeordnet ist. Ein Verfahren zum Herstellen des Schaltungsträgers mit einem darin integrierten Transformator weist mindestens die folgenden Schritte auf: Aufeinanderstapeln der Lagen des Schaltungsträgers, wobei in eine Untermenge der Lagen des Schaltungsträgers Lagen des Transformators integriert sind, und folgend Verbinden der Lagen des Schaltungsträgers.

Die DE 10 2014 209881 A1 beschreibt mehrlagige induktive Bauelemente, die sich in Low Temperature Cofired Ceramics/LTCC (bei niederer Temperatur gesinterte Keramik) einbetten lassen, sowie einen mehrlagigen Leiterplattenaufbau, der die Herstellung der eingebetteten Bauelemente durch Co-Firing ermöglicht. Eine dielektrische Abdeckung, die entweder aus dem Material des Schaltungsträgers oder aus einem mit dem Material des Schaltungsträgers kompatiblen dielektrischen Material beschaffen ist, wird auf die magnetischen Keramiklagen laminiert. Bei monolithischer keramischer Bauweise werden die mehrlagigen dielektrischen und magnetischen Leiterplattenteile durch Vorsintern des Ferrits und eine angepasste Kavität mechanisch entkoppelt, so dass das Sintern im Verbund auch bei nicht angepassten Werkstoffen möglich ist.

Der Erfindung liegt demgegenüber die Aufgabe zugrunde, ein verbessertes elektronisches Bauelement und ein Verfahren zu dessen Herstellung zu schaffen.

Die der Erfindung zugrunde liegende Aufgabe wird jeweils mit den Merkmalen der unabhängigen Patentansprüche gelöst. Ausführungsformen der Erfindung sind in den abhängigen Patentansprüchen angegeben.

Nach Ausführungsformen der Erfindung hat das elektronische Bauelement eine Kavität, in der ein magnetischer Kreis angeordnet ist. Der magnetische Kreis wird durch zumindest eine Planarspule gebildet, die sich zwischen ersten und zweiten magnetischen Leiterelementen befindet. Die magnetischen Leiterelemente haben jeweils ein erstes Ende, wobei die ersten Enden einander gegenüberliegend angeordnet sind und sich in axialer Richtung der Planarspule erstrecken. Durch die einander gegenüberliegenden ersten Enden der magnetischen Leiterelemente wird ein Spulenkern für die Planarspule gebildet.

Die zweiten Enden der magnetischen Leiterelemente sind an der Peripherie der Planarspule angeordnet und liegen sich dort einander gegenüber. Die magnetischen Leiterelemente weisen jeweils zumindest einen brückenförmigen Bereich auf, der die ersten und zweiten Enden des betreffenden magnetischen Leiterelements miteinander verbindet, wodurch der magnetische Kreis geschlossen wird. Die brückenförmigen Bereiche der magnetische Leiterelemente können sich dabei jeweils parallel zu der Ebene der Planarspule zwischen deren Zentrum und deren Peripherie erstrecken, sodass die Windungen der Planarspule zwischen den ersten und zweiten Enden sowie den aneinander gegenüberliegenden brückenförmigen Bereichen der zwei einander gegenüberliegend angeordneten Leiterelemente hindurch verlaufen.

Ausführungsformen der Erfindung sind besonders vorteilhaft, da sich bei einer relativ kleinen Masse des elektronischen Bauelements eine relativ große Induktivität erreichen lässt. Ferner kann die Bauhöhe des elektronischen Bauelements aufgrund der Planarspule gering sein, sodass sich bei einer Anordnung des elektronischen Bauelements beispielsweise auf einer Leiterplatte auch bei hohen Beschleunigungen nur ein geringes Kippmoment ergibt. Ausführungsformen des elektronischen Bauelements sind daher besonders geeignet für Transportmittel, wie zum Beispiel Automobile, Flugzeuge und Schiffe, in denen hohe mechanische Beanspruchungen auftreten können und/oder für Anwendungen, bei denen es auf besondere Zuverlässigkeit ankommt, wie zum Beispiel medizintechnische Geräte, insbesondere Implantate.

Ausführungsformen der Erfindung sind ferner besonders vorteilhaft, da sich eine relativ große Induktivität bei einem relativ kleinen ohmschen Widerstand realisieren lässt und somit die Blindleistung und die Abwärme entsprechend gering sind. Das elektronische Bauelement kann beispielsweise eine Leistungsaufnahme zwischen 10 Watt und 100 Watt, insbesondere 50 Watt, aufweisen.

Nach Ausführungsformen der Erfindung haben die ersten und zweiten magnetische Leiterelemente jeweils mehrere der brückenförmigen Bereiche, die zum Beispiel stern-, insbesondere x-förmig, jeweils um die ersten Enden herum angeordnet sind. Dabei können die einzelnen brückenförmigen Bereiche eines der magnetischen Leitelemente in äquidistanten oder unterschiedlichen Winkelabständen um das erste Ende des betreffenden magnetischen Leitelement herum angeordnet sein.

Nach Ausführungsformen der Erfindung ist die zumindest eine Planarspule auf einer Leiterplattenschicht aufgebracht. Die Planarspule wird beispielsweise in einem separaten Fertigungsprozess beispielsweise lithografisch hergestellt, um die Planarspule dann anschließend für die Herstellung des elektronischen Bauelements zu verwenden.

Nach einer Ausführungsform der Erfindung beinhaltet das elektronische Bauelement eine erste Planarspule zur Bildung der Primärseite eines Transformators und eine zweite Planarspule zur Bildung der Sekundärseite eines Transformators. Die ersten und zweiten Planarspulen sind zwischen den ersten und zweiten magnetischen Leiterelemente angeordnet, wobei die ersten Enden den Spulenkern, d.h. hier den Transformatorkern, des Transformators bilden.

Beispielsweise können die Planarspulen spiegelsymmetrisch zueinander ausgebildet sein, indem diese mit identischen lithografischen Prozessen hergestellt werden. Dies hat den Vorteil, dass hierdurch eine geringe Exemplarstreuung des elektronischen Bauelements erreichbar ist.

Nach einer Ausführungsform der Erfindung werden zum Beispiel die ersten und/oder zweiten Planarspulen dadurch gebildet, dass die betreffende Planarspule einen ersten Teil ihrer Windungen auf einer ersten Seite ihrer Leiterplattenschicht hat und ein zweiter Teil der Windungen der Planarspule auf der der ersten Seite gegenüberliegenden zweiten Seite der Leiterplattenschicht angeordnet ist. Die ersten und zweiten Teile werden durch die Leiterplattenschicht hindurch durch ein Via verbunden, sodass hierdurch eine Planarspule resultiert, die Windungsabschnitte auf den zwei gegenüberliegenden Seiten der durch die Leiterplattenschicht gebildeten Ebene aufweist. Dies hat den Vorteil, dass hierdurch die Induktivität bei geringen Kosten, geringem Materialeinsatz und geringer Bauhöhe weiter erhöht werden kann.

Nach Ausführungsformen der Erfindung wird ein Spulenpaket, beispielsweise mit einer Planarspule oder ersten und zweiten Planarspulen als eine bauliche Einheit dadurch geschaffen, dass weitere Leiterplattenschichten als Isolationsschichten für die Spulenwindungen vorgesehen sind. Eine solche bauliche Einheit kann in einem separaten Prozess hergestellt werden, um die bauliche Einheit dann anschließend für die Herstellung des elektronischen Bauelements zu verwenden, indem die bauliche Einheit zwischen die ersten und zweiten magnetischen Leiterelemente eingebracht wird.

Nach einer Ausführungsform der Erfindung sind die ersten und zweiten magnetischen Leiterelemente so ausgebildet, dass sich die jeweils gegenüberliegenden zweiten Enden mit deren Stirnflächen berühren, wodurch eine besonders gute mechanische Stabilität geschaffen wird. Insbesondere wird ein Kippen der magnetischen Leiterelemente relativ zueinander auch bei großen mechanischen Belastungen vermieden, da sich die magnetischen Leiterelemente an deren zweiten Enden aufeinander abstützen.

Nach einer Ausführungsform der Erfindung besteht ein Luftspalt zwischen den ersten Enden der Leiterelemente in dem Zentrum der zumindest einen Planarspule. Ein solcher Luftspalt kann vorteilhaft sein, um einen Betriebspunkt in der magnetischen Sättigung zu vermeiden. Insbesondere ermöglicht der Luftspalt einen Betrieb des elektronischen Bauelements im näherungsweise linearen Bereich der Hysteresekurve des magnetischen Kreises. Auf der anderen Seite ist der Luftspalt zwischen den ersten Enden auch mechanisch vorteilhaft, da so eine Doppelpassung relativ zu den zweiten Enden vermieden wird und ein definierter mechanischer Kontakt an den gegenüberliegenden zweiten Enden hergestellt wird.

Nach einer Ausführungsform der Erfindung wird die Kavität, in der der magnetische Kreis angeordnet ist, durch eine oder mehrere Leiterplattenschichten des elektronischen Bauelements gebildet, wobei die Leiterplattenschichten einen thermischen Ausdehnungskoeffizienten haben, der größer ist als der thermische Ausdehnungskoeffizient des Ferrit aus dem die magnetischen Leiterelemente bestehen. Bei einer Temperaturerhöhung dehnt sich dann die Kavität stärker aus als der magnetische Kreis, sodass es zu einem Spalt zwischen dem magnetischen Kreis und der Kavität kommen könnte. Um den magnetischen Kreis innerhalb der Kavität auch bei einer Temperaturerhöhung sicher zu fixieren, kann ein elastisches Element in der Kavität angeordnet sein, um eine solche Spaltbildung aufgrund einer Temperaturerhöhung zu vermeiden. Bei dem elastischen Element kann es sich um ein Federelement handeln und/oder einen Schaumstoff, beispielsweise Polyurethan.

Nach einer Ausführungsform der Erfindung werden eines oder mehrere der Federelemente in eine Leiterplattenschicht geformt, beispielsweise durch Einpressen und/oder Laserbearbeitung. Eine solche Leiterplattenschicht mit Federelementen kann in dem elektronischen Bauelement integriert sein, wobei sich das oder die Federelemente jeweils in einer der Kavitäten befindet, um dort den Toleranzausgleich aufgrund einer Temperaturerhöhung zu bewirken.

Nach Ausführungsformen wird die Kavität des elektronischen Bauelements durch ein oder mehrere Leiterplattenschichten gebildet. Nach Ausführungsformen haben die Leiterplattenschichten einen thermischen Ausdehnungskoeffizient, der größer ist als der thermische Ausdehnungskoeffizient des Ferrit, aus dem die magnetischen Leiterelemente bestehen, und mit zumindest einem elastischen Element, welches in der Kavität angeordnet ist, wobei das elastische Element zum Gegeneinanderdrücken der ersten und zweiten magnetischen Leiterelemente als Ausgleich der unterschiedlichen Ausdehnungskoeffizienten ausgebildet ist. Nach Ausführungsformen wird das elastische Element durch ein Federelement gebildet. Nach Ausführungsformen beträgt der Federweg des Federelements 10 µm bis 30 µm. Nach Ausführungsformen ist das elektronische Bauelement als Multilayer-Bauelement ausgebildet und eine Leiterplattenschicht des Multilayer-Bauelements beinhaltet das Federelement. Nach Ausführungsformen wird das elastische Element durch in der Kavität angeordneten Schaumstoff gebildet.

Nach einer Ausführungsform der Erfindung ist die Summe der Stirnflächen der zweiten Enden der magnetischen Leiterelemente gleich der Summe der Stirnflächen der ersten Enden. Wenn jedes der magnetischen Leiterelemente nur ein zweites Ende hat, sind also die Stirnflächen der zweiten Enden gleich groß wie der Stirnflächen der ersten Enden, sodass der Querschnitt des magnetischen Kreises an den ersten und zweiten Enden jeweils näherungsweise gleich ist.

Haben die magnetische Leiterelemente dagegen jeweils mehrere zweite Enden, wie zum Beispiel zwei, drei oder vier zweite Enden bei einer x-förmigen Ausbildung, so hat im letzteren Fall jede Stirnfläche der zweiten Enden in etwa ein Viertel der Stirnfläche des zweiten Endes, sodass sich auch in diesem Fall wiederum ein näherungsgleicher wirksamer Querschnitt des magnetischen Kreises an den ersten Enden bzw. den zweiten Enden ergibt, was für die Leitung des magnetischen Flusses vorteilhaft ist.

In einem weiteren Aspekt betrifft die Erfindung eine Leiterplatte, die einschichtig oder mehrschichtig ausgeführt sein kann, mit einem erfindungsgemäßen elektronischen Bauelement, das auf oder in der Leiterplatte angeordnet sein kann. Insbesondere kann das elektronische Bauelement als diskretes elektronisches Bauelement ausgebildet sein. Das elektronische Bauelement kann beispielsweise Anschlusskontakte in SMD-Technik aufweisen, die elektrische Kontakte mit einer Schaltung der Leiterplatte herstellen und das elektronische Bauelement auf der Leiterplatte fixieren.

Nach einer Ausführungsform der Erfindung ist das elektronische Bauelement als Transformator ausgebildet und dient zur Verfügungstellung einer Betriebsspannung für eine Schaltung der Leiterplatte. Die Schaltung der Leiterplatte kann zum Beispiel zur Ansteuerung einer Leuchtdiode dienen, wie zum Beispiel für die Leuchtdiode eines Autoscheinwerfers.

In einem weiteren Aspekt betrifft die Erfindung ein Verfahren zur Herstellung eines elektronischen Bauelements. Ein Spulenpaket bestehend aus einer oder mehreren Planarspulen wird zunächst hergestellt. Das Spulenpaket wird zwischen die ersten und zweiten magnetischen Leiterelemente gebracht und in eine Kavität einer ein- oder mehrschichtigen Leiterplatte eingebracht.

Nach einer Ausführungsform der Erfindung werden die einzelnen Komponenten des elektronischen Bauelements zunächst in einem Stapelaufbau angeordnet, der durch Aufbringung von Druck bei erhöhter Temperatur in einem sogenannten Multilayer-Prozess zu einer baulichen Einheit geformt wird.

Im Weiteren werden Ausführungsformen der Erfindung mit Bezugnahme auf die Figuren näher erläutert. Es zeigen:
- Figur 1: einen Querschnitt durch einen Stapelaufbau einer ersten Ausführungsform eines erfindungsgemäßen elektronischen Bauelements,
- Figur 2: eine Ausführungsform der Primär- und Sekundärspulen,
- Figur 3: eine Ausführungsform der Herstellung der Primär- und Sekundärspulen,
- Figur 4: eine Ausführungsform der ersten und zweiten magnetischen Leiterelemente,
- Figur 5: eine Ausführungsform eines elektronischen Bauelements mit einem Federmechanismus,
- Figur 6: eine Ausführungsform eines Stapelaufbaus des elektronischen Bauelements mit Federmechanismus,
- Figur 7: den Stapelaufbau der Figur 6 nach Durchführung eines MultilayerProzesses,
- Figur 8: eine Ausführungsform eines elektronischen Bauelements mit einem Schaumstoff,
- Figur 9: eine weitere Ausführungsform eines elektronischen Bauelements mit einem Schaumstoff,
- Figur 10: eine Ausführungsform einer Leiterplatte mit einer Ausführungsform eines darauf angeordneten diskreten elektronischen Bauelements,
- Figur 11: eine Ausführungsform eines LAN Übertragers mit Common Mode Choke,
- Figur 12: eine Ausführungsform eines SEPIC-Wandlers.

In der nachfolgenden Beschreibung der Ausführungsformen werden einander entsprechende oder gleiche Elemente mit jeweils identischen Bezugszeichen gekennzeichnet.

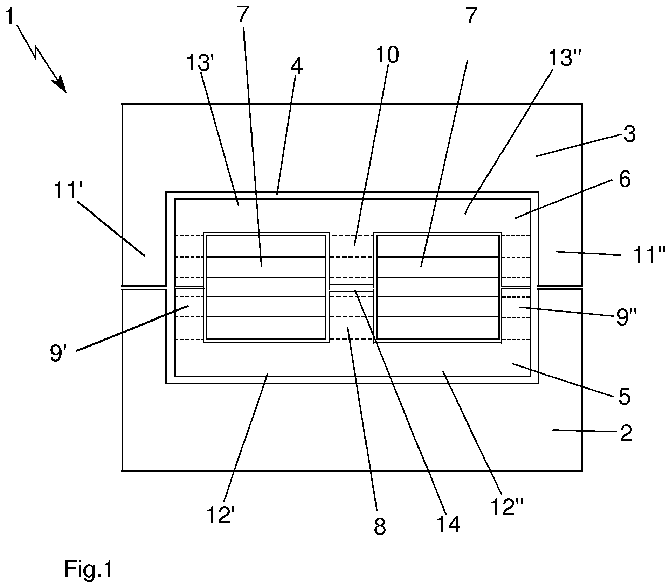

Die Figur 1 zeigt eine Querschnittsansicht einer Ausführungsform eines erfindungsgemäßen diskreten elektronischen Bauelements 1. Das Bauelement 1 hat beispielsweise eine untere Leiterplattenschicht 2 und eine obere Leiterplattenschicht 3, die so geformt sind, dass zwischen den Leiterplattenschichten 2 und 3 eine Kavität 4 resultiert. Die Kavität kann gefräst sein oder bei höheren Stückzahlen mit einem entsprechenden Formwerkzeug in beide oder zumindest in eine Leiterplattenschicht eingebracht, z.B. geprägt werden, z.B. mittels einer Prägewalze.
Bei den Leiterplattenschichten kann es sich jeweils um ein sogenanntes Prepreg handeln. Insbesondere kann es sich hierbei um eine mit Epoxidharz getränkte Glasfasermatte (zum Beispiel FR-4-Materialien) handeln.

In der Kavität 4 ist ein magnetischer Kreis angeordnet, der durch ein erstes magnetisches Leiterelement 5, ein zweites magnetisches Leiterelement 6 und ein zwischen den Leiterelementen 5 und 6 angeordnetes Spulenpaket 7 mit zumindest einer Planarspule gebildet wird. Das magnetische Leiterelement 5 hat ein erstes Ende 8, welche in eine zentrale Öffnung des Spulenpakets 7 in axialer Richtung hineinragt. Das magnetische Leiterelement 5 hat ferner zwei zweite Enden 9' und 9" an der Peripherie des Spulenpakets 7.

Das magnetische Leiterelement 6 hat ein entsprechendes erstes Ende 10, welches dem ersten Ende 8 in der zentralen Öffnung des Spulenpakets 7 gegenüberliegt sowie zweite Enden 11' und 11", die den zweiten Enden 9' bzw. 9" gegenüberliegen. Beispielsweise sind die magnetischen Leiterelemente 5 und 6 identisch ausgebildet, sodass bei der Massenfertigung des Bauelements 1 gleiche Bauteile zur Realisierung der Leiterelemente 5 und 6 verwendet werden können.

Die Leiterelemente 5, 6 können beispielsweise bügelförmig ausgebildet sein. In der Ausführungsform der Figur 1 haben die Leiterelemente 5, 6 jeweils zwei brückenförmigen Bereiche, d. h. das Leiterelement 5 hat die brückenförmigen Bereiche 12' und 12", die das erste Ende 8 jeweils mit den zweiten Enden 9' bzw. 9" verbinden und das magnetische Leiterelement 6 hat die brückenförmigen Bereiche 13' und 13", die jeweils das erste Ende 10 mit den zweiten Enden 11' bzw. 11" verbinden.

Die magnetischen Leiterelemente 5, 6 bestehen jeweils aus einem Ferrit einer hohen magnetischen Permeabilität.

Die Windungen der Planarspule des Spulenpakets 10 verlaufen in der Darstellung gemäß Figur 1 senkrecht zur Zeichenebene kreisförmig um die ersten Enden 8 und 10 herum. Durch die ersten Enden 8, 10 wird der Spulenkern gebildet. Der magnetische Kreis wird durch die brückenförmigen Bereiche, die das Spulenpaket 7 überbrücken, geschlossen, und zwar einerseits durch die einander gegenüberliegenden zweiten Enden 9' und 11' sowie andererseits durch die einander gegenüberliegenden Enden 9" und 11".

Die Figur 1 zeigt das Bauelement 1 in einem Stapelaufbau, in dem die Leiterplattenschichten 2 und 3 zu einer baulichen Einheit miteinander verbunden werden, wobei dies durch einen an sich bekannten Leiterplattenprozess erfolgen kann. Beispielsweise werden hierzu die Leiterplattenschichten 2 und 3 bei erhöhter Temperatur aufeinandergepresst.

Nach Ausführungsformen der Erfindung liegen die zweiten Enden 9' und 11' bzw. 9" und 10" mit ihren Stirnflächen aufeinander auf, wohingegen zwischen den Stirnflächen der ersten Enden 8 und 10 ein Luftspalt 14 verbleibt.

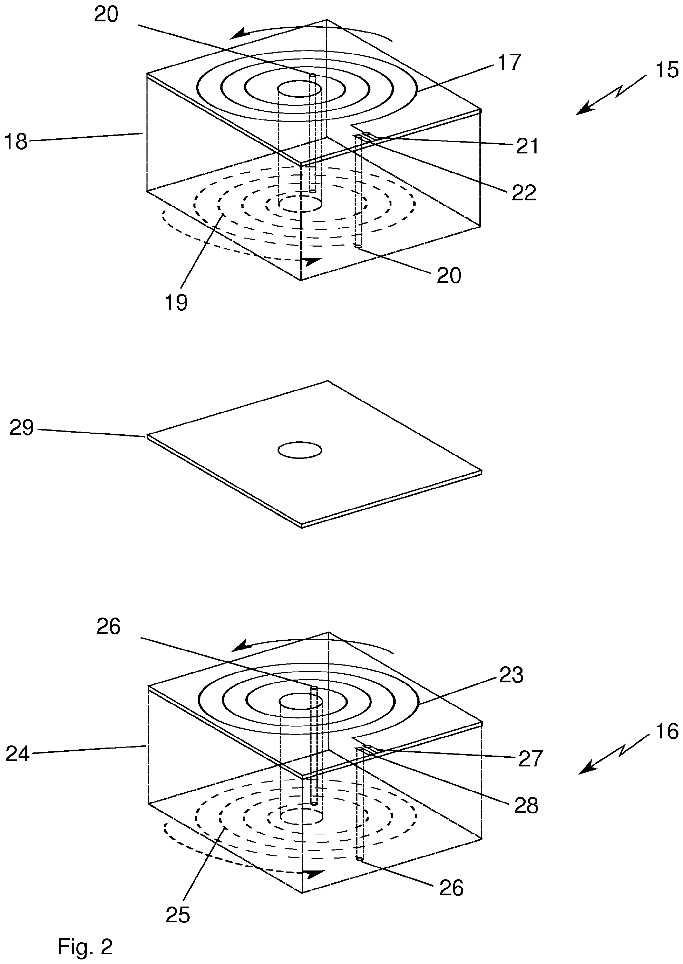

Die Figur 2 zeigt eine Ausführungsform der Erfindung zur Herstellung des Spulenpakets 7 mit einer Primärspule 15 und einer Sekundärspule 16.

Zur Herstellung der Primärspule 15 wird so vorgegangen, dass zunächst ein erster Teil 17 der Windungen der Primärspule 15 zum Beispiel auf der Oberseite einer Leiterplattenschicht 18 zum Beispiel lithografisch aufgebracht wird, wohingegen ein zweiter Teil 19 der Windungen der Primärspule 15 auf der Unterseite der Leiterplattenschicht 18 aufgebracht wird. Die Teile 17 und 19 der Primärspule 15 werden durch eine Durchkontaktierung 20, das heißt ein sogenanntes Via, durch die Leiterplattenschicht 18 hindurch elektrisch miteinander verbunden. Die resultierende Primärspule 15 hat Anschlusskontakte 21 und 22.

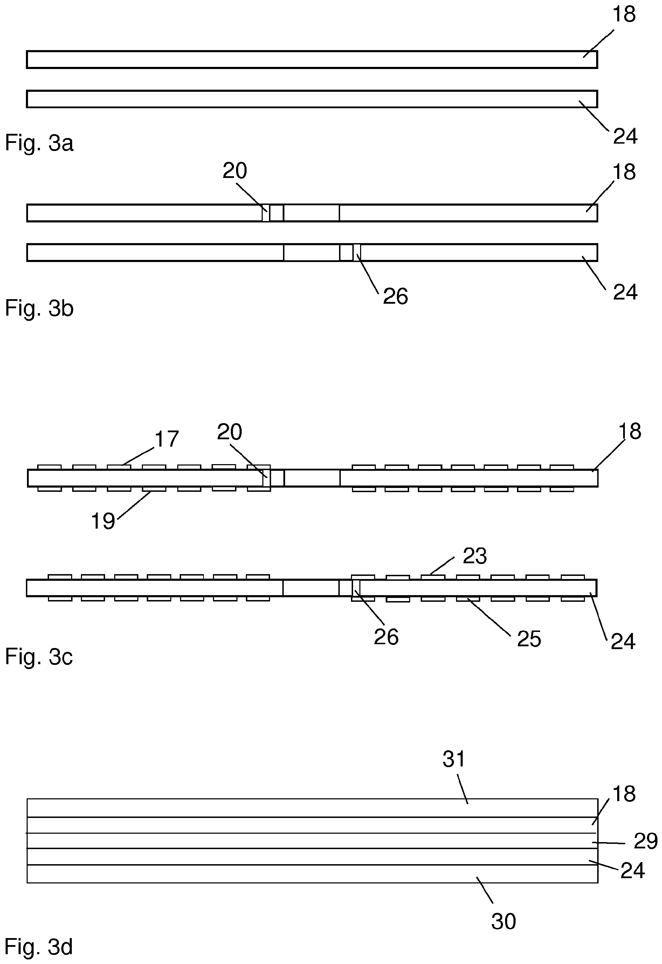

Zur Herstellung der Sekundärspule 16 wird in analoger Weise vorgegangen, indem ein Teil 23 der Windungen der Sekundärspule 16 zum Beispiel auf der Oberseite einer Leiterplattenschicht 24 aufgebracht wird und ein zweiter Teil 25 der Sekundärspule 16 auf die Unterseite der Leiterplattenschicht 24 aufgebracht wird, wobei die Teile 23 und 25 durch eine Durchkontaktierung 26 (vergleiche Figur 3b) elektrisch miteinander verbunden sind. Die resultierende Sekundärspule 16 hat die Anschlusskontakte 27 und 28.

Die Figur 3 zeigt die entsprechenden Verfahrensschritte. Im ersten Schritt (Figur 3a) werden die Leiterplattenschichten 18 und 24 zur Verfügung gestellt. Im zweiten Schritt (Figur 3b) werden die Durchkontaktierungen 20 bzw. 26 in die Leiterplattenschichten 18 bzw. 24 eingebracht, wobei dies mithilfe an sich bekannter Verfahren zur Herstellung sogenannter Vias erfolgen kann. Nach einer Ausführungsform der Erfindung werden zuerst die Durchkontaktierungen 20 bzw. 26 hergestellt und danach erfolgt die Leiterbahnerstellung.

In dem dritten Schritt (Figur 3c) werden die Primärspule 15 bzw. die Sekundärspule 16 hergestellt, indem die Teile 17 und 19 bzw. 22 und 23 auf die Oberseite bzw. Unterseite der jeweiligen Leiterplattenschichten 18 bzw. 24 aufgebracht werden. Die Herstellung der Primärspule 15 erfolgt also dadurch, dass zunächst die Leiterplattenschicht 18 mit der Durchkontaktierung 20 versehen wird und dass dann anschließend die Leiterbahn des Teils 17 der Windungen der Primärspule 15 auf die Oberseite der Leiterplattenschicht 18 und der Teil 19 der Windungen der Primärspule 15 auf die Unterseite der Leiterplattenschicht 18 aufgebracht wird, wobei die Teile 17 und 19 der Windungen über die Durchkontaktierung 20 miteinander verbunden sind. In analoger Art und Weise wird vorgegangen, um die Sekundärspule 16 mit den Teilen 23 und 25 der Windung der Sekundärspule 16 herzustellen, indem der Teil 23 auf die Oberseite der Leiterplattenschicht 24 und der Teil 25 auf die Unterseite der Leiterplattenschicht 24 aufgebracht wird, nachdem die Durchkontaktierung 26 hergestellt wurde.

Im vierten Schritt wird dann das Spulenpaket 7 geformt (Figur 3d), indem zwischen die Leiterplattenschichten 18 und 24 eine weitere Schicht 29, unter die Leiterplattenschicht 24 eine weitere Schicht 30 und auf die Leiterplattenschicht 18 eine weitere Schicht 31 aufgebracht wird, wobei die weiteren Schichten 29, 30 und 31 als elektrische Isolatoren wirken. Durch einen an sich bekannten Leiterplattenprozess wird aus den Schichten 30, 24, 29, 18 und 31 eine mehrschichtige Leiterplatte (sogenannte Multilayer Printed Circuit Board - MLPCB) als bauliche Einheit zur Realisierung des Spulenpakets 7 geschaffen.

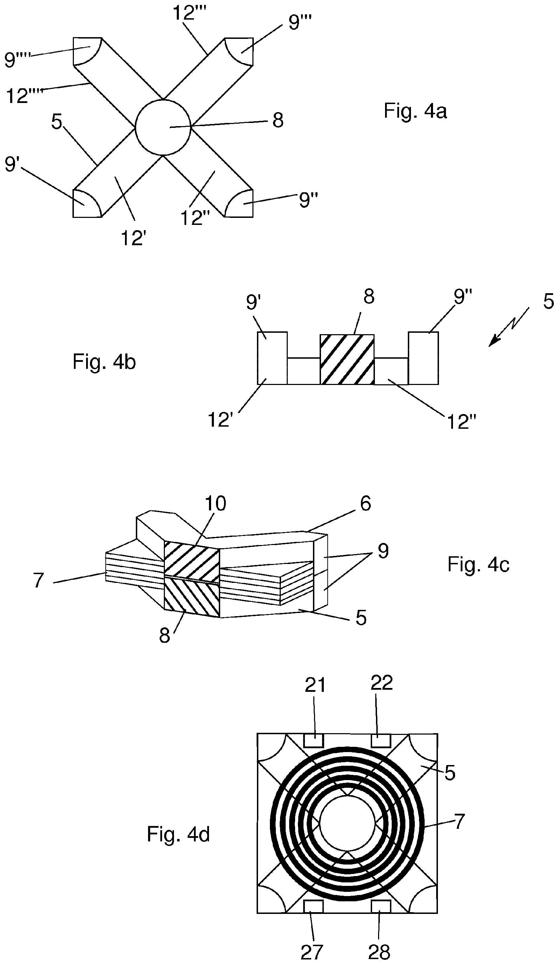

Die Figur 4a zeigt eine Draufsicht auf eine weitere Ausführungsform eines magnetischen Leiterelements 5, welches hier x-förmig mit vier brückenförmigen Bereichen 12 ausgebildet ist. Die einzelnen brückenförmigen Bereiche schließen hier jeweils einen rechten Winkel miteinander ein. Es sind auch Ausführungsformen möglich, in denen die brückenförmigen Bereiche gleiche oder unterschiedliche Winkel miteinander einschließen. Ebenso kann die Anzahl der brückenförmigen Bereiche, die ein einzelnes der Leiterelemente 5, 6 aufweist, variieren, und z.B. 2, 3,4, 5 oder 6 betragen. Die Anzahl der brückenförmigen Bereiche ist bei beiden Leiterelemente 5, 6 identisch.

Bei der Ausführungsform gemäß Figur 4a ist die Summe der Stirnflächen der zweiten Enden 9, d. h. 9', 9", 9''' und 9'''', gleich der Stirnfläche des ersten Endes 8, was für die Leitung des magnetischen Fluss vorteilhaft ist, der sich der wirksame Querschnitt nicht verengt.

Die Figur 4b zeigt einen seitlichen Schnitt des magnetischen Leiterelements 5 der Figur 4a.

Die Figur 4c zeigt in einer perspektivischen Ansicht die magnetischen Leiterelemente 5 und 6, die bei der hier betrachteten Ausführungsform identisch zueinander sind.

Die Figur 4d zeigt in einer Draufsicht den resultierenden magnetischen Kreis mit den in fertiger Bauweise übereinander angeordneten Leiterelementen 5 (oben, nicht dargestellt) und 6 und dem dazwischen befindlichen Spulenpaket 7.

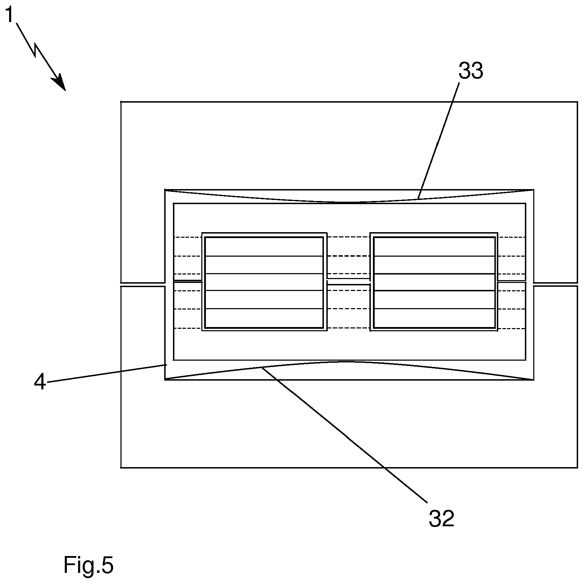

Die Figur 5 zeigt eine Ausführungsform des Bauelements 1 mit Federelementen 32, 33, die in der Kavität 4 angeordnet sind, um die magnetischen Leiterelemente 5 bzw. 6 gegeneinander zu drücken. Hierdurch wird sichergestellt, dass auch bei Temperaturänderungen und den damit einhergehenden Längenänderungen der Kavität 4 und der Ferritkerne die magnetischen Leiterelemente 5 und 6 mechanisch miteinander in Kontakt bleiben, sodass der magnetische Kreis intakt bleibt.

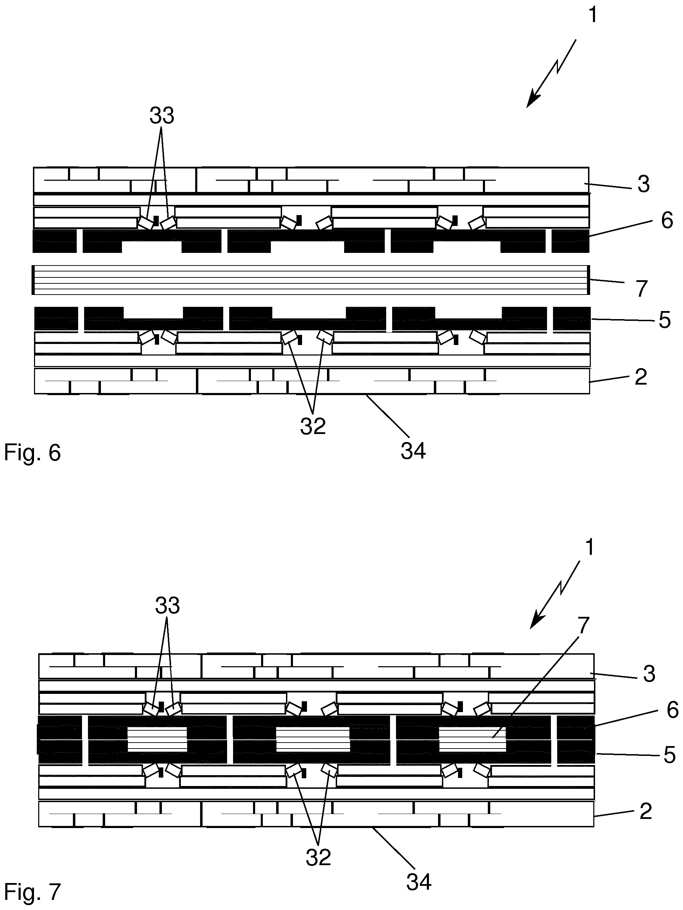

Die Figur 6 zeigt einen Ausschnitt einer Ausführungsform des Bauelements 1, wobei in dem Bauelement 1 ein Spulenpaket 7 mit drei Paaren Primär- und Sekundärspulen eingebracht ist. Federelemente 32 bzw. 33 können in einer Materialschicht, z.B. einer Glasfasermatte oder einem Prepreg Material geformt sein, die Teil des Schichtaufbaus des Bauelements 1 ist. Die Federelemente 32 bzw. 33 sind dazu ausgebildet, die magnetischen Leiterelemente 5 bzw. 6 nach Durchführung des Multilayerprozesses gegeneinander zu drücken, wie in der Fig. 7 dargestellt, insbesondere auch bei Temperaturänderungen und den damit einhergehenden Längenänderungen der Kavität 4 und der Ferritkerne.

Die Figur 6 zeigt das Bauelement 1 als Stapelaufbau vor der Durchführung des Multilayer-Prozesses; die Figur 7 zeigt das Bauelement 1 im fertiggestellten Zustand, nach Durchführung des Multilayer-Prozesses, durch den eine bauliche Einheit des Bauelements 1 geschaffen wird.

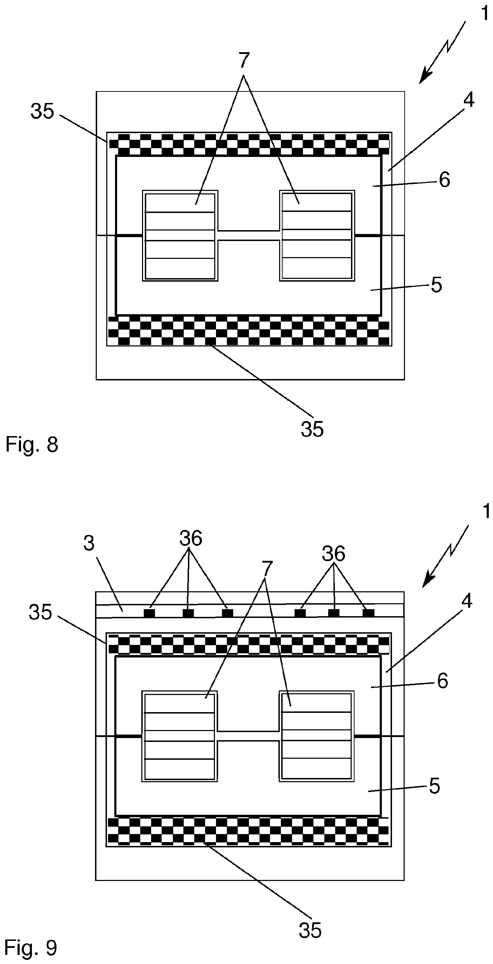

Die Figur 8 zeigt eine zu der Figur 5 alternative Ausführungsform, bei der die Federelemente 32, 33 durch eine Schaumstofffüllung der Kavität 4 an deren Ober- und Unterseite ersetzt werden. Beispielsweise kommt hierzu Polyurethanschaumstoff 35 zum Einsatz.

Die Figur 9 zeigt eine Weiterbildung der Ausführungsform gemäß Figur 8, wobei bei der Ausführungsform gemäß Figur 9 elektronische Bauteile 36 auf oder in der Leiterplattenschicht 3 angeordnet sind. Diese elektronischen Bauteile 36 können mit dem Spulenpaket 7 verschaltet sein.

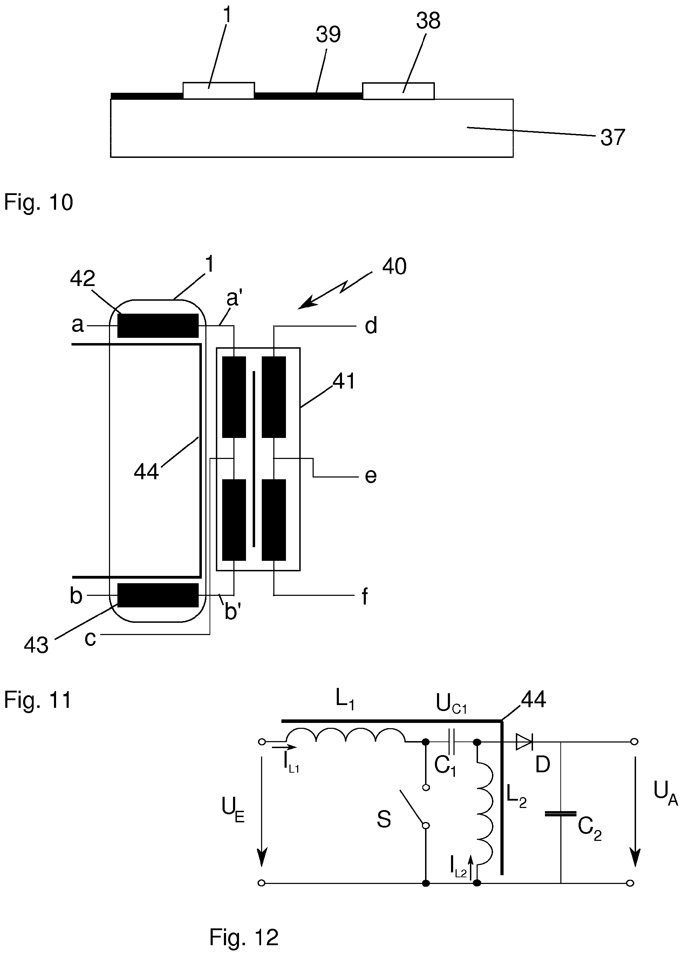

Die Figur 10 zeigt eine Leiterplatte 37 mit einer elektronischen Schaltung 38 und einer Ausführungsform eines elektronischen Bauelements 1 gemäß der Erfindung. Beispielsweise ist das Bauelement 1 als Transformator ausgebildet und mit der elektronischen Schaltung über Leiterbahnen 39 der Leiterplatte 37 verbunden, um die Schaltung 38 mit einer Betriebsspannung zu versorgen, wenn eine Spannungsquelle (nicht dargestellt) an das Bauelement 1 angeschlossen wird.

Beispielsweise handelt es sich bei der Schaltung 38 um eine Ansteuerung für einen Autoscheinwerfer.

Ausführungsformen eines erfindungsgemäßen elektronischen Bauelements können als Entstör-Drossel verwendet werden, insbesondere als stromkompensierte Drossel oder Gleichtaktdrossel (Common Mode Choke - CMC). Solche stromkompensierten Drosseln sind an sich aus dem Stand der Technik bekannt und werden zur Dämpfung von Störemissionen eingesetzt. Für Gleichtakt-Störungen bildet eine stromkompensierte Drossel eine sehr hohe Induktivität, da sich die Störströme in ihr nicht kompensieren. Zu diesem Zweck werden stromkompensierte Drosseln an Ein- und Ausgängen von Schaltnetzteilen sowie in Netzfiltern eingesetzt, insbesondere auch in LAN Übertragern.

Die Figur 11 zeigt eine Ausführungsform eines LAN-Übertragers 40, der einen Übertrager 41 beinhaltet sowie eine Ausführungsform des Bauelements 1, welches hier als Gleichtaktdrossel, d.h. als CMC ausgebildet und verschaltet ist.

Das Bauelement 1 ist hier als 4-Pol ausgebildet, und zwar entsprechend der Ausführungsform gemäß Figuren 2 - 9 mit zwei Planarspulen, die zu dem von den magnetischen Leiterelementen 5 und 6 gebildeten magnetischen Kreis 44 gehören. Die erste Planarspule 42 (vergleiche Primärspule 15) hat die Anschlüsse a (entsprechend Anschlusskontakt 21) und a' (entsprechend Anschlusskontakt 22) und die zweite Planarspule 43 hat den Anschlusskontakt b (entsprechend Anschlusskontakt 27) und den Anschlusskontakt b' (entsprechend Anschlusskontakt 28).

Der Übertrager 41 hat die Signaleingänge d und f sowie die Masseleitung e. Ausgangsseitig hat der Übertrager 41 die Masseleitung c und ist mit den Anschlusskontakten a' und b' des Bauelements 1 verbunden, um zum Beispiel ein an den Signaleingängen d und f anliegendes Eingangssignal über den Übertrager 41 und den durch das Bauelement 1 gebildeten Common Mode Choke in ein LAN-Kabel einzukoppeln, welches sich auf Seiten des Common Mode Choke 1 befindet.

Nach Ausführungsformen der Erfindung wird ein erfindungsgemäßes Bauelement 1 zur Realisierung eines Gleichspannungswandlers, insbesondere eines Kondensator-gekoppelten Schaltreglers, insbesondere für einen SEPIC-Wandler (Abkürzung für Single Ended Primary Inductance Converter), einen CUK-Wandler oder Zeta-Wandler verwendet.

Die Figur 12 zeigt das Schaltbild eines SEPIC-Wandlers, so wie er prinzipiell aus dem Stand der Technik bekannt ist (https://de.wikipedia.org/wiki/sepic). Im Unterschied zum Stand der Technik wird erfindungsgemäß die Induktivität L1 und L2 durch eine Ausführungsform des erfindungsgemäßen Bauelements 1 realisiert, wobei die Induktivitäten L1 und L2 zu dem magnetischen Kreis 44 gehören, der durch die Leiterelemente 5 und 6 gebildet wird. Der Kopplungsfaktor der Induktivitäten L1 und L2 kann beispielsweise 0,5 bis 0,9, insbesondere 0,6 bis 0,8 betragen. Die elektronischen Bauelemente des SEPIC-Wandlers können dabei gemäß der Ausführungsform nach Figur 9 angeordnet sein, vergleiche die dort gezeigten elektronischen Bauelemente 36.

Der SEPIC-Wandler gemäß Figur 12 kann für den Betrieb von LEDs als Fahrlicht im Auto als DC/DC-Wandler eingesetzt werden. Bei der Eingangsspannung U_{E} kann es sich um die Bordspannung eines Kraftfahrzeugs von ca. 12 V handeln und bei der Ausgangsspannung U_{A} um die für den Betrieb eines LED-Moduls erforderliche Betriebsspannung von zum Beispiel ca. 6,6 V.

### Bezugszeichenliste

- 1: Bauelement
- 2: Leiterplattenschicht
- 3: Leiterplattenschicht
- 4: Kavität
- 5: erstes magnetisches Leiterelement
- 6: zweites magnetisches Leiterelement
- 7: Spulenpaket
- 8: erstes Ende
- 9': zweites Ende
- 9": zweites Ende
- 10: erstes Ende
- 11': zweites Ende
- 11": zweites Ende
- 12': brückenförmiger Bereich
- 12": brückenförmiger Bereich
- 13': brückenförmiger Bereich
- 13": brückenförmiger Bereich
- 14: Luftspalt
- 15: Primärspule
- 16: Sekundärspule
- 17: Teil
- 18: Leiterplattenschicht
- 19: Teil
- 20: Durchkontaktierung
- 21: Anschlusskontakt
- 22: Anschlusskontakt
- 23: Teil
- 24: Leiterplattenschicht
- 25: Teil
- 26: Durchkontaktierung
- 27: Anschlusskontakt
- 28: Anschlusskontakt
- 29: Leiterplattenschicht
- 30: Leiterplattenschicht
- 31: Leiterplattenschicht
- 32: Federelement
- 33: Federelement
- 34: Anschlusspad
- 35: Polyurethanschaumstoff
- 36: elektronisches Bauteil
- 37: Leiterplatte
- 38: elektronische Schaltung
- 39: Leiterbahnen
- 40: LAN-Übertrager
- 41: Übertrager
- 42: Planarspule
- 43: Planarspule
- 44: magnetischer Kreis

## Patentansprüche

1. Elektronisches Bauelement mit einer Kavität (4), in der ein magnetischer Kreis (44) angeordnet ist, wobei der magnetische Kreis durch erste (5) und zweite (6) magnetische Leitelemente gebildet wird, zwischen denen sich zumindest eine Planarspule (7; 15, 16; 42, 43; L1, L2) befindet, wobei die magnetischen Leiterelemente jeweils zumindest einen brückenförmigen Bereich (12, 13) aufweisen, und die Windungen der Planarspule zwischen den brückenförmigen Bereichen der magnetischen Leitelemente hindurch verlaufen, wobei die brückenförmigen Bereiche jeweils ein erstes Ende (8, 10) aufweisen, wobei durch die einander gegenüberliegenden ersten Enden ein Spulenkern für die Planarspule gebildet wird, und die brückenförmigen Bereiche jeweils ein zweites Ende (9', 9"; 11', 11") aufweisen, wobei durch die einander gegenüberliegenden zweiten Enden der magnetische Kreis an der Peripherie der Planarspule geschlossen wird, wobei die ersten und zweiten magnetischen Leiterelemente so ausgebildet sind, dass sich die jeweils gegenüberliegenden zweiten Enden mit deren Stirnflächen berühren und wobei ein Luftspalt (14) zwischen den ersten Enden der Leiterelemente in einem Zentrum der zumindest einen Planarspule ausgebildet ist.

2. Elektronisches Bauelement nach Anspruch 1, wobei die magnetischen Leiterelemente jeweils bügel-, stern- oder x-förmig ausgebildet sind und mehrere der brückenförmigen Bereiche aufweisen, insbesondere vier brückenförmige Bereiche, die in äquidistanten oder unterschiedlichen Winkelabständen um die ersten Enden herum angeordnet sind.

3. Elektronisches Bauelement nach Anspruch 1 oder 2, wobei die zumindest eine Planarspule auf einer Leiterplattenschicht (18; 24) aufgebracht ist

4. Elektronisches Bauelement nach Anspruch 3, mit einer ersten Planarspule (15) zur Bildung der Primärseite eines Transformators und einer zweiten Planarspule (16) zur Bildung der Sekundärseite eines Transformators, wobei die ersten und zweiten Planarspulen zueinander beispielsweise spiegelsymmetrisch angeordnet sind.

5. Elektronisches Bauelement nach Anspruch 3 oder 4, wobei ein erster Teil (17) der zumindest einen Planarspule auf einer ersten Seite der Leiterplattenschicht (18) angeordnet ist und ein zweiter Teil (19) der Planarspule auf einer der ersten Seite gegenüberliegenden zweiten Seite der Leiterplattenschicht (18) angeordnet ist, wobei die ersten und zweiten Teile der Planarspule durch ein durch die Leiterplattenschicht hindurchverlaufendes Via (20) elektrisch miteinander verbunden sind.

6. Elektronisches Bauelement nach Anspruch 5, wobei die ersten und zweiten Planarspulen auf ersten bzw. zweiten der Leiterplattenschichten (18; 24) ausgebildet sind, wobei zwischen den ersten und zweiten Leiterplattenschichten sowie jeweils auf der Oberfläche der ersten und zweiten Leiterplattenschichten Isolationsschichten (29, 30, 31) angeordnet sind, wobei durch die ersten und zweiten Leiterplattenschichten und die Isolationsschichten ein Spulenpaket (7) als bauliche Einheit gebildet wird.

7. Elektronisches Bauelement nach Anspruch 6, wobei das Spulenpaket zwischen den ersten und zweiten magnetischen Leiterelementen angeordnet ist, wobei die Kavität so ausgebildet ist, dass der magnetische Kreis in der Kavität fixiert ist, sodass sich zumindest die zweiten Enden der gegenüberliegenden Leiterelemente (5, 6) berühren, wobei die brückenförmigen Bereiche der Leiterelemente sich jeweils parallel zu den ersten und zweiten Planarspulen erstrecken.

8. Elektronisches Bauelement nach einem der vorhergehenden Ansprüche, wobei die Stirnfläche des ersten Endes der Summe der Stirnflächen der zweiten Enden eines der Leiterelemente gleicht, wobei die ersten und zweiten Leiterelemente vorzugsweise eine identische Form aufweisen.

9. Leiterplatte mit mindestens einer Leiterplattenschicht (37) und mit einem elektronischen Bauelement (1) nach einem der vorhergehenden Ansprüche, das auf oder in der Leiterplattenschicht (37) angeordnet ist.

10. Leiterplatte nach Anspruch 9 mit einer elektronischen Schaltung (38), die eine Betriebsspannung benötigt, wobei das elektronische Bauelement mit der elektronischen Schaltung zur Verfügungstellung der Betriebsspannung elektrisch verbunden ist.

11. Entstör-Drossel mit einem elektronischen Bauelement (1) nach einem der vorhergehenden Ansprüche, insbesondere stromkompensierte Drossel oder Gleichtaktdrossel.

12. Schaltnetzteil oder Netzfilter mit einer Entstör-Drossel nach Anspruch 11.

13. Gleichspannungswandler, insbesondere SEPIC-Wandler, mit einem elektronischen Bauelement (1) nach einem der vorhergehenden Ansprüche 1 bis 8.

14. Verfahren zur Herstellung eines elektronischen Bauelements (1) nach einem der vorhergehenden Ansprüche 1 bis 8 mit folgenden Schritten:
- Herstellung der zumindest einen Planarspule auf einem Substrat (18; 24),
- Aufbringung von Isolationsschichten (29, 30, 31) auf das Substrat zur Bildung eines Spulenpakets (7),
- Einbringung des magnetischen Kreises mit dem zwischen den ersten und zweiten magnetischen Leiterelementen angeordneten Spulenpaket in eine Kavität (4), die in zumindest einer Leiterplattenstruktur (2, 3) ausgebildet wird.

15. Verfahren nach Anspruch 14, wobei die Ausbildung der Kavität (4) durch ein Form- oder Stempelwerkzeug, insbesondere eine Prägewalze, erfolgt und/oder wobei durch die Leiterplattenstruktur (2.3) und den magnetischen Kreis ein Stapelaufbau gebildet wird, der durch Aufbringung von Druck in einem Multilayer-Prozess zu einer baulichen Einheit geformt wird.
